# EUROPEAN PATENT APPLICATION

(11) **EP 1 538 664 A1**
(43) Date of publication of application: **08.06.2005**
(21) Application number: 03795208.2
(22) Date of filing: 04.08.2003
(51) Int. Cl.: H01L 21/308

(54) **ETCHANT AND ETCHING METHOD**

(30) Priority: 13.09.2002 JP 2002269291; 29.11.2002 JP 2002346823
(71) Applicant: Daikin Industries, Ltd., Osaka-shi, Osaka 530-8323 (JP)
(72) Inventor: ITANO, Mitsushi Yodogawa Seisakusho, Settsu-shi, Osaka 566-0044 (JP); KANEMURA, Takashi Yodogawa Seisakusho, Settsu-shi, Osaka 566-0044 (JP); MOMOTA, Hiroshi Yodogawa Seisakusho, Settsu-shi, Osaka 566-0044 (JP); WATANABE, Daisuke Yodogawa Seisakusho, Settsu-shi, Osaka 566-0044 (JP)
(74) Representative: Luderschmidt, Schüler & Partner GbR
(86) International application number: PCT/JP2003/009848
(87) International publication number: WO 2004/025718

(57) **Abstract**

An etching solution having an etch rate of 2 Å/minute or greater for a film having a relative dielectric constant of 8 or higher (a High-k film, and whose ratio of the etch rate of a thermal oxide (THOX) film to that of a High-k film is ([THOX etch rate]/[High-k film etch rate]) is 50 or less.

## Description

### TECHNICAL FIELD

The present invention relates to an etching solution, a method for producing an etched article and an etched article obtained by the method.

### BACKGROUND OF THE INVENTION

In recent years, there has been an increased need for narrowing gate widths due to the miniaturization of semiconductor devices. According to a scaling law, this also requires the effective film thickness of a gate insulating film to be thin. However, if an SiO₂ film, which is currently used as a gate insulating film in silicon devices, is further thinned, this renders a problem of increased current leakage and/or decreased reliability. To solve this problem, a method wherein a physical film thickness is increased by using a high-dielectric material (High-k material) for a gate insulating film has been proposed. Examples of such high-dielectric materials are hafnium oxide, zirconium oxide films, etc. These High-k films usually have extremely high etching resistivity. An etching solution that can etch a High-k film, if it etches too quickly a THOX, TEOS or the like Si oxide film that is formed on an Si substrate prior to the High-k film etching process, is undesirable, because the Si oxide film will be etched to such an extent that it cannot achieve its function as an Si oxide film. Therefore, there is a demand for an etching solution that can etch High-k films while its silicon oxide film etching speed is suppressed (for example, see Experimental observation of the thermal stability of High-k gate dielectric material on silicon, P. S. Lysaght et al., Journal of Non-Crystalline Solids, 303(2002) 54-63; Integration of High-k gate stack systems into planar CMOS process flows, H. R. Huff et al., IWGI 2001, Tokyo; Selective & Non-Selective Wet Etching, M. Itano et al., Wafer Clean & Surface Prep Workshop, International Sematech).

An object of the present invention is to provide an etching solution that can etch a High-k film but etch a silicon oxide film at a reduced speed.

### BRIEF DESCRIPTION OF THE DRAWINGS

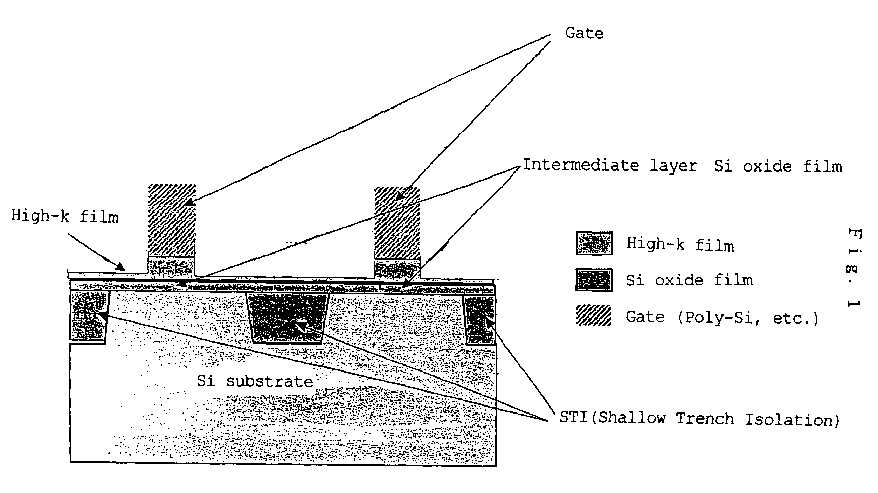

Fig. 1 schematically shows an example of an etched article of the present invention.

### DISCLOSURE OF THE INVENTION

The present invention relates to the inventions described in the following items.

Item 1. An etching solution having an etch rate of 2 Å/minute or greater for a film having a relative dielectric constant of 8 or higher (a High-k film), and whose ratio of the etch rate for a thermal oxide (THOX) film to the etch rate for a High-k film ([THOX etch rate]/[High-k film etch rate]) is 50 or less.

Item 2. An etching solution according to Item 1, wherein the High-k film has a relative dielectric constant of 15 or greater.

Item 3. An etching solution according to Item 1, wherein the High-k film is a hafnium oxide film, a zirconium oxide film, or a lanthanum oxide film.

Item 4. An etching solution according to Item 1, wherein the High-k film comprises at least one member selected from the group consisting of hafnium silicate (HfSiOₓ), hafnium aluminate (HfAlO), HfSiON, HfAlON, ZrSiO, ZrAlO, ZrSiON, ZrAlON, alumina (Al₂O₃), HfON, ZrON and Pr₂O₃.

Item 5. An etching solution according to Item 1, wherein the etch rate for the thermal oxide (THOX) film is 100 Å/minute or less.

Item 6. An etching solution according to Item 1, which contains hydrogen fluoride (HF).

Item 7. An etching solution according to Item 1 wherein the hydrogen fluoride concentration is 3 mass% or greater.

Item 8. An etching solution according to Item 1, which contains hydrogen fluoride and an organic solvent comprising a heteroatom.

Item 9. An etching solution according to Item 8, wherein the organic solvent comprising a heteroatom is an ether compound, a ketone compound, or a sulfur-containing heterocyclic compound.

Item 10. An etching solution according to Item 9, wherein the organic solvent comprising a heteroatom is an ether compound.

Item 11. An etching solution according to Item 10, wherein the ether compound is at least one member selected from the group consisting of compounds represented by General Formula (1)

R¹-O-(CH₂CH₂-O)ₙ-R² (1)

wherein n is 1, 2, 3 or 4, R¹ and R² may be the same or different and each represents a hydrogen atom, a lower alkyl group or a lower alkyl carbonyl group, with the proviso that R¹ and R² are not both hydrogen atoms.

Item 12. An etching solution according to Item 10, wherein the ether compound has a relative dielectric constant of 30 or less.

Item 13. An etching solution according to Item 8, wherein the organic solvent comprising a heteroatom contains at least one carbonyl group in its molecular.

Item 14. An etching solution according to Item 8, wherein the organic solvent comprising a heteroatom has at least one hydroxy group in its molecular.

Item 15. An etching solution according to Item 10, wherein the ether compound is at least one member selected from the group consisting of tetrahydrofuran, tetrahydropyran, furan, furfural, γ-butyrolactone, monoglyme, diglyme, and dioxane.

Item 16. An etching solution according to Item 10, wherein the ether compound is at least one member selected from the group consisting of ethylene glycol methyl ethyl ether, ethylene glycol diethyl ether, diethylene glycol methyl ethyl ether, diethylene glycol diethyl ether, triethylene glycol dimethyl ether, triethylene glycol diethyl ether, triethylene glycol ethylmethyl ether, tetraethylene glycol dimethyl ether, tetraethylene glycol diethyl ether, and polyethylene glycol dimethyl ether.

Item 17. An etching solution according to Item 10, wherein the ether compound is at least one member selected from the group consisting of ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triethylene glycol monomethyl ether acetate and triethylene glycol monoethyl ether acetate.

Item 18. An etching solution according to Item 10, wherein the ether compound is at least one member selected from the group consisting of an ethylene glycol monomethyl ether, ethylene glycol monoethyl ether, ethylene glycol monopropyl ether, polyethylene glycol monomethyl ether, ethylene glycol monoisopropyl ether, ethylene glycol monobutyl ether, propylene glycol monomethyl ether, propylene glycol monopropyl ether and propylene glycol monobutyl ether.

Item 19. An etching solution according to Item 9, wherein the sulfur-containing heterocyclic compound is at least one member selected from the group consisting of sulfolane and propane sultone.

Item 20. An etching solution according to Item 1, which contains hydrogen fluoride (HF) and an organic solvent comprising a heteroatom, wherein the ratio of HF : heteroatom-comprising organic solvent : water = 3 mass% or greater : 50 to 97 mass% : 10 mass% or less.

Item 21. A method for producing an etched article using the etching solution of Item 1, the method comprising a step of etching an object to be etched having a silicon oxide film and a film having a relative dielectric constant of 8 or greater, and a gate electrode that is formed on the film having a relative dielectric constant of 8 or greater.

Item 22. An etched article obtained by the method of Item 21.

The etching solution of the present invention has a ratio of the etch rate of a thermal oxide (THOX) film relative to that of a film having a high relative dielectric constant (High-k film) ([THOX etch rate]/[High-k film etch rate]), i.e., etching selectivity, of 50 or less. According to a preferable embodiment of the present invention, the etching solution of the present invention has an etch rate for a High-k film of 2 Å/minute or greater, preferably about 5 Å/minute or greater, and more preferably about 10 to 30 Å/minute.

A film having a relative dielectric constant of about 8 or greater, preferably about 15 or greater, and more preferably about 20 to 40 is used as the film having a high relative dielectric constant (High-k film). The upper limit of the relative dielectric constant is about 50. Examples of materials for such High-k films are hafnium oxide, zirconium oxide, lanthanum oxide, hafnium silicates (HfSiOₓ), hafnium aluminates (HfAlOₓ), HfSiON, HfAlON, ZrSiO, ZrAlO, ZrSiON, ZrAlON, alumina (Al₂O₃), HfON, ZrON, Pr₂O₃, etc. The relative dielectric constant of each material is as follows: alumina = 8.5 to 10, aluminates (HfAlO, HfAlON, ZrAlO, ZrAlON) = 10 to 20, silicates (HfSiO, HfSiON, ZrSiO, ZrSiON) = 10 to 20, hafnium oxides = 24, and zirconium oxides = 11 to 20.

The etching solution of the present invention has a ratio of THOX etch rate to that of High-k film (THOX etch rate/High-k film etch rate) of 50 or less, preferably about 20 or less, more preferably about 10 or less, still more preferably about 5 or less, yet still more preferably about 1 or less, and particularly preferably about 1/10 or less.

It is preferable that the ratio of etch rates of High-k film to THOX be within the above mentioned ranges for the following reasons:

In a process for fabricating a semiconductor device, during a step of etching a High-k gate oxide film, an Si oxide film is formed on an Si substrate to separate each device in an IC by STI (Shallow Trench isolation) or like method, and on the gate oxide film, a thin interlayer of an Si oxide film is formed between a High-k oxide layer and an Si substrate (see Fig. 1). When a High-k film is overetched in the process of etching a High-k gate oxide film, and if a base film thereof, i.e., an Si oxide film, is etched, the capabilities of the film are adversely affected, and this causes problems. An ideal etching solution is one that does not etch Si oxide films but etches only High-k films. However, unless the High-k films have an extremely high uniformity in the thickness and etch rate, and just etching is conducted, these Si oxide films will not be etched, and therefore, no problems arise. When the etching selectivity is within the above range, it is possible to not etch the Si oxide film by controlling the etching time, etc., and is therefore preferable. If the etching solution has an etching selectivity within the above range, even when a High-k film is overetched, it is possible to control the degree of overetching so that is does not adversely affect the abilities of the Si oxide film. Because the Si oxide film of the interlayer is etched from the side, it takes a long time to be etched, and therefore if etching selectivity is within the above range, it is possible to control so that the Si oxide film is etched to an extent that does not cause any problems.

The etching solution of the present invention has an etch rate for a High-k film about 2 Å/minute or greater, preferably about 5 Å/minute or greater, and more preferably about 10 Å/minute or greater.

From the viewpoint of throughput in the wet etching process of a High-k gate oxide film, it is preferable that the etch rate of High-k film be about 2 Å/minute or greater.

All that is necessary for the etching solution of the invention is that the requirements, i.e., its High-k film etch rate is 2 Å/minute or greater and the ratio of the High-k film etch rate to thermal oxide (THOX) film etch rate is 50 or less, are met at a temperature within the range that the etching solution can etch. In other words, it is necessary that the etching solution of the present invention meets the two requirements described above at a desired temperature. Preferably, the etching solution meets the two requirements at any one temperature not less than 20°C, more preferably in the range from 20°C to the boiling point of the solvent, more preferably about 20 to 90°C, still more preferably about 20 to 60°C, and still further more preferably about 20 to 30°C.

The etching solution of the present invention has a THOX etch rate of about 100 Å/minute or less, preferably about 50 Å/minute or less, more preferably about 20 Å/minute or less, and particularly preferably about 1 Å/minute or less. The etching solution temperature depends on the type of the etching solution, and may be any temperature as long as the etching solution can etch and meet the above requirements, preferably any temperature 20°C or greater, and more preferably any temperature within the range from 20°C to not more than the boiling point of the solvent, more preferably any temperature within the range from 20 to 60°C, and still more preferably from 20 to 30°C.

If an etching solution can etch a thermal oxide (THOX) film in such a manner to have an etch rate ratio relative to High-k film in the range as described above, the etching solution can also etch TEOS or other like silicon oxide films at a similar ratio.

The etch rate of the etching solution of the present invention can be obtained by dividing the difference in thickness of the film (High-k film, THOX, TEOS and like silicon oxide films, etc.) before and after etching using the etching solution of the present invention by the etching time.

Examples of etching solutions of the present invention are those containing hydrogen fluoride (HF), preferably those containing hydrogen fluoride and an organic solvent comprising a heteroatom.

The HF content is preferably about 3 mass% or more and more preferably about 10 mass% or more. The upper limit of the HF content is not particularly limited; however, it is preferably about 50 mass%, more preferably about 35 mass%, and still more preferably about 25 mass%. Usually, when the HF content is great, the High-k film etch rate tends to be high. In contrast, when the HF content is small, the ratio of the etch rates of THOX to High-k film ([THOX etch rate]/[High-k film etch rate]) tends to be small. Therefore, the HF concentration can be suitably selected depending on the desired High-k film etch rate and the desired ratio of etch rates of THOX to High-k films.

Hydrofluoric acid (cone.; 50 mass% solution) is usually used as HF; however, when an etching solution without water is preferable, 100% HF may also be used.

A method for preparing an etching solution containing hydrogen fluoride (HF) is that, when hydrofluoric acid (conc.) is used, a hydrofluoric acid (conc.) solution is added to an organic solvent comprising a heteroatom or heteroatoms. When 100% HF is used, the 100% HF is mixed with a solution or the 100% HF is diluted. In this case, attention has to be paid to the heat generated during dilution.

Preferable examples of organic solvents comprising a heteroatom or heteroatoms are ether compounds, ketone compounds, sulfur-containing compounds, etc.

Among these, ether compounds are preferable.

Ether compounds may be open-chain compounds or cyclic compounds, and preferable examples thereof are those represented by the following General Formula (1).

R¹-O-(CH₂CH₂-O)ₙ-R² (1)

wherein n is 1, 2, 3 or 4, R¹ and R² may be the same or different and each represents a hydrogen atom, a lower alkyl group or a lower alkyl carbonyl group, with the proviso that R¹ and R² are not both hydrogen atoms at the same time.

As a lower alkyl group, an alkyl group having about 1 to 3 carbon atoms is preferably used, examples thereof include the methyl, ethyl, n-propyl, and isopropyl groups.

Preferable examples of lower alkyl groups of a lower alkyl carbonyl group are C₁-C₃ alkyl groups (methyl, ethyl, n-propyl, and isopropyl), and examples of lower alkyl carbonyl groups are acetyl, propionyl, butyryl and isobutyryl.

Examples of preferable compounds represented by General Formula (1) are monoglyme (n = 1); diglyme and diethylene glycol diethyl ether (n = 2); triethylene glycol dimethyl ether (n = 3); and tetraethylene glycol dimethyl ether (n = 4).

Examples of other ether compounds are tetrahydrofuran, tetrahydropyran, furan, furfural, γ-butyrolactone, dioxane, etc.

Among these ether compounds, monoglyme, diglyme, tetrahydrofuran, diethylene glycol diethyl ether, triethylene glycol dimethyl ether, tetraethylene glycol dimethyl ether, dioxane, and γ-butyrolactone are preferable, and monoglyme is particularly preferable.

As ether compounds, those having a relative dielectric constant of 30 or less can be preferably used. Examples of ether compounds having a relative dielectric constant of 30 or less include monoglyme, diglyme, tetrahydrofuran, dioxane, γ-butyrolactone, etc.

Examples of ketone compounds are γ-butyrolactone and like cyclic compounds.

Examples of sulfur-containing compounds are sulfolane, propane sultone and like cyclic compounds.

The etching solution of the present invention may contain water. When it contains water, the content of water is 10 mass% or less, preferably 5 mass% or less, and more preferably about 3 mass%. However, as the etching solution of the present invention, those without water are preferable.

A preferable example of an etching solution of the present invention is:
. HF : organic solvent comprising a heteroatom (preferably, ether compound) : water = 3 mass% or greater : 50 to 97 mass% : 10 mass% or less.
   More specifically, the following etching solutions are exemplified:
. HF : monoglyme : water = 3 to 50 mass% : 50 to 97 mass% : 0 to 10 mass%
. HF : diglyme : water = 3 to 50 mass% : 50 to 97 mass% : 0 to 10 mass%
. HF : dioxane : water = 3 to 50 mass% : 50 to 97 mass% : 0 to 10 mass%
. HF : tetrahydrofuran : water = 3 to 50 mass% : 50 to 97 mass% : 0 to 10 mass%
. HF : diethylene glycol diethyl ether : water = 1 to 20 mass% : 70 to 99 mass% : 0 to 10 mass%
. HF : triethylene glycol dimethyl ether : water = 1 to 20 mass% : 70 to 99 mass% : 0 to 10 mass%
. HF : tetraethylene glycol dimethyl ether : water = 1 to 20 mass% : 70 to 99 mass% : 0 to 10 mass%

The etching solution of the present invention can be suitably used for etching an object that has a High-k film, and a THOX, TEOS and/or like silicon oxide film on the surface of a silicon substrate.

The etching solution can be used in a process for fabricating a semiconductor. The fabrication process comprises, for example, the steps of: forming an isolation region on the silicon substrate by embedding THOX, TEOS or like silicon oxide in a trench to form a High-k film; forming a gate electrode; and forming a gate insulating film by etching the High-k film using, for example, the gate electrode as a mask.

Before conducting etching using the etching solution of the present invention, dry etching may be conducted in such a manner that some portion of the High-k film remains unetched. In other words, when a High-k film is etched by two-step etching, sometimes the top portion of the High-k film is etched by dry etching and wet etching is conducted to remove the rest of the High-k film. The etching solution of the present invention can be used in the wet etching.

In the etching method of the present invention, the etching solution temperature is not limited as long as the High-k film and the THOX can be etched at desired etch rates with a desired etching selectivity, and it can be suitably selected depending on the type of High-k film and etching solution, and other conditions. For example, in the case of an etching solution containing hydrogen fluoride, when the hydrogen fluoride concentration is high, the requirement "High-k film etch rate of 2 Å/minute or greater" can be met at a relatively low temperature; however, when the hydrogen fluoride concentration is low, it is necessary to conduct etching at a relatively high temperature to meet this requirement.

Therefore, the temperature may be suitably selected so as to meet the requirements of the present invention depending on the kind of the etching solution and content of each component of the etching solution. The etching solution temperature is usually about 20 to 90°C and preferably about 20 to 60°C.

The etching treatment can be conducted by following a conventional method, for example, dipping an object to be etched in an etching solution. The duration of dipping is not limited as long as it can etch the High-k film and the THOX to a desired thickness at a desired etch rate and etching selectivity. Therefore the dipping time can be suitably selected depending on the types of High-k film and etching solution, solution temperature of the etching solution, etc. The dipping time is usually about 1 to 30 minutes and preferably about 1 to 10 minutes.

The semiconductor substrate etched using the etching solution of the present invention can be fabricated into various types of semiconductor devices by employing conventional methods (for example, methods disclosed in Atlas of IC Technologies: An Introduction to VLSI Processes by W. Maly, 1987 by The Benjamin/Cummings Publishing Company Inc.).

The present invention provides an etching solution that can etch a High-k film, while etching a silicon oxide film at a suppressed etch rate.

### BEST MODE FOR CARRYING OUT THE INVENTION

Examples of the present invention are described below; however the scope of the present invention is not limited to or by these examples.

### Examples 1 to 13 and Comparative Examples 1 to 10

Etching solutions which contain HF and solvent in the ratio as shown in Tables 1, 2, 3 and 4 were prepared. Etch rates and etching selectivity of each solution were obtained in respect to each test substrate comprising, on a silicon substrate, a hafnium oxide film (MOCVD HfO₂ Asdep) formed by MOCVD, a film formed by annealing the hafnium oxide film (MOCVD HfO₂ Anneal), a hafnium silicate film (HfSiO) formed by MOCVD and annealing, alumina (Al₂O₃) formed by MOCVD and annealing, or thermal oxide (THOX) film.

The etch rate was determined by measuring the thicknesses of the films before and after etching and dividing the thickness diference by the etching time.

The thicknesses of the films were measured using an Auto EL-III ellipsometer manufactured by Rudolf Research.

Etching was conducted by dipping each test substrate into an etching solution for 10 minutes.

Table 1 shows the etch rates and etching selectivity of each etching solution (Examples 1 to 6 and Comparative Examples 1 to 6) for a MOCVD HfO₂ Asdep, MOCVD HfO₂ Anneal, and thermal oxide (THOX) film at an etching temperature of 50°C.

Table 2 shows the etch rates and etching selectivity of etching solution (Examples 7 to 11 and Comparative Examples 7 to 8) containing an ether compound solvent as set forth in Claim 9, using the same HF concentration and water concentration (0%) at the same etching temperature (60°C), for etching MOCVD HfO₂Asdep, MOCVD HfO₂ Anneal, and thermal oxide film (THOX).

Tables 3 and 4 show the etch rates and etching selectivity of monoglyme and HF in an anhydrous hydrofluoric acid-containing etching solutions (Examples 12 and 13, and Comparative Examples 9 and 10) for MOCVD HfSiO Anneal film, MOCVD Al₂O₃ Anneal film, and thermal oxide (THOX) film.

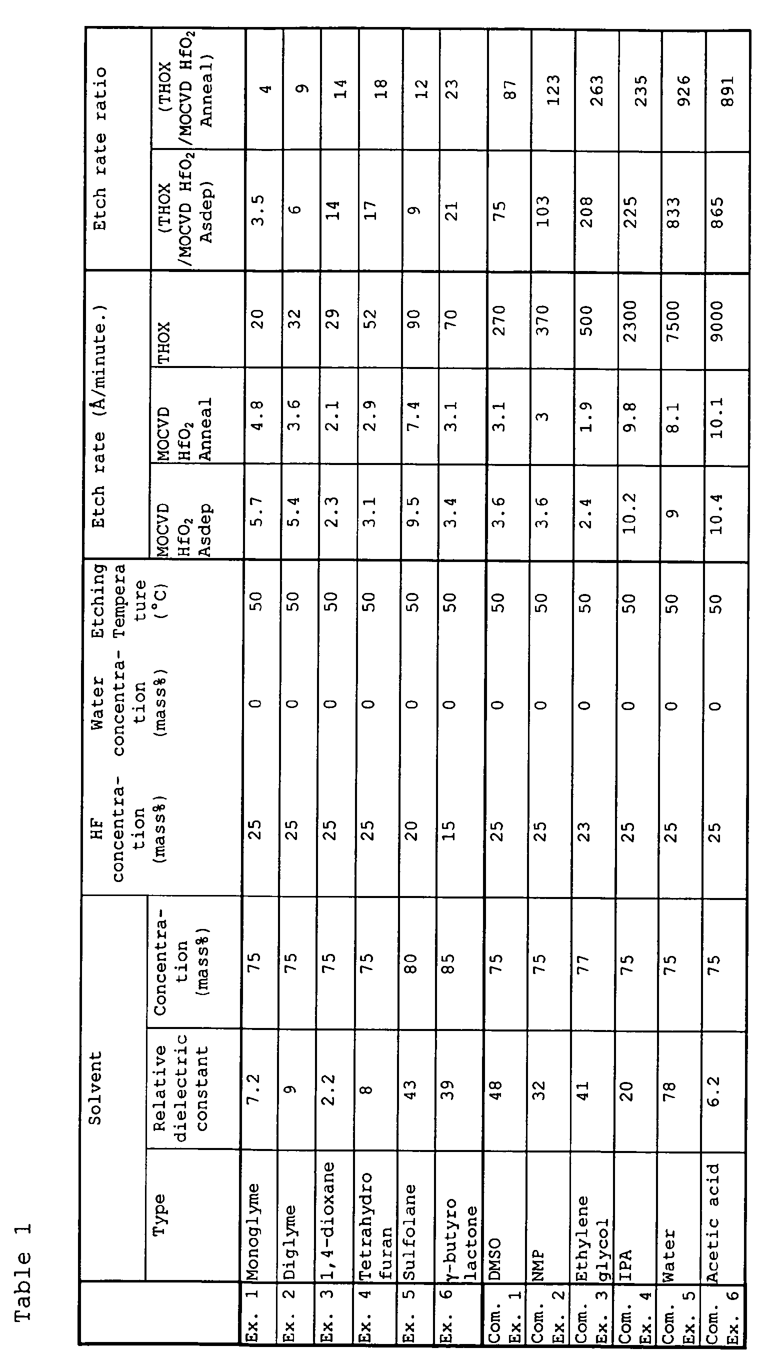

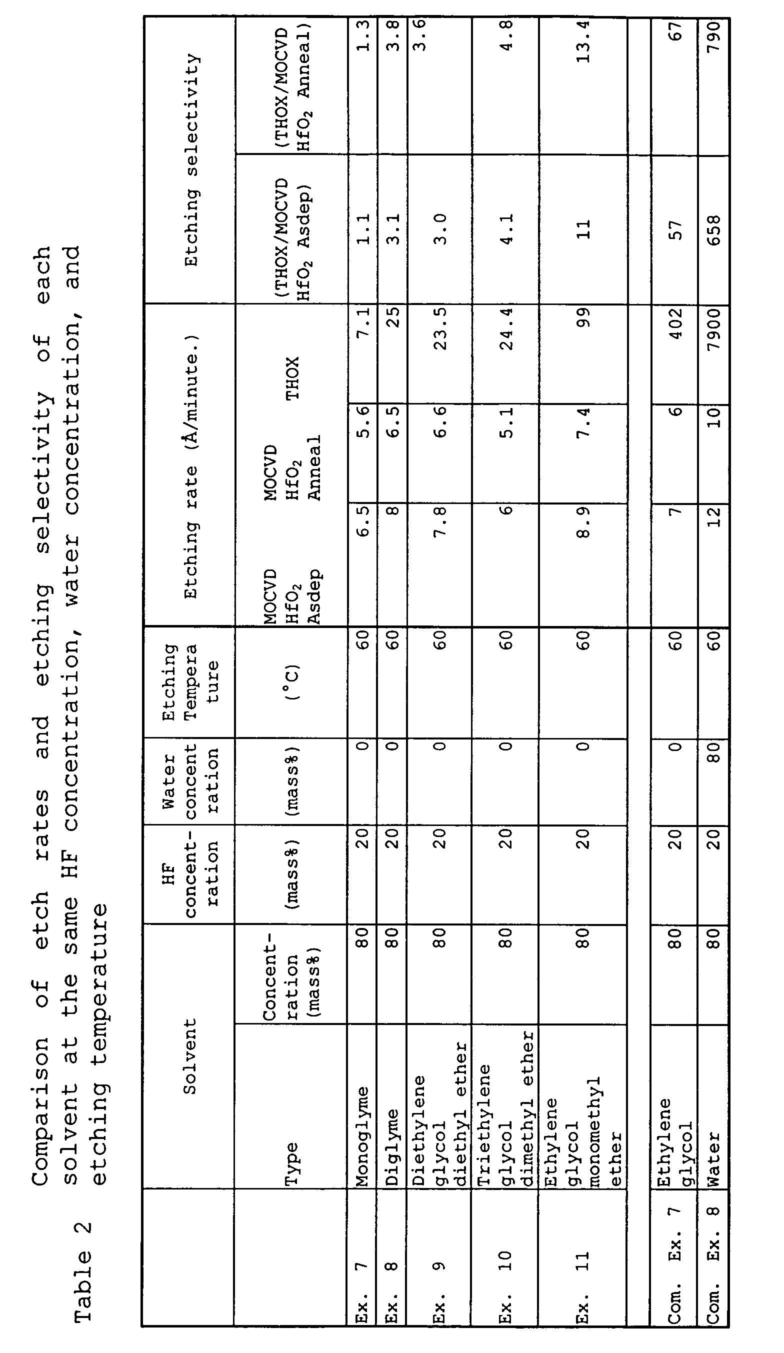

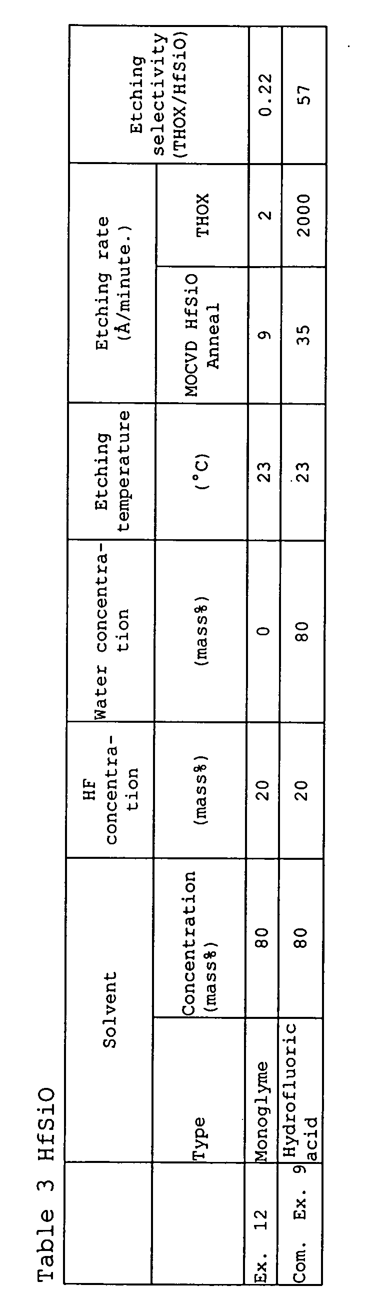

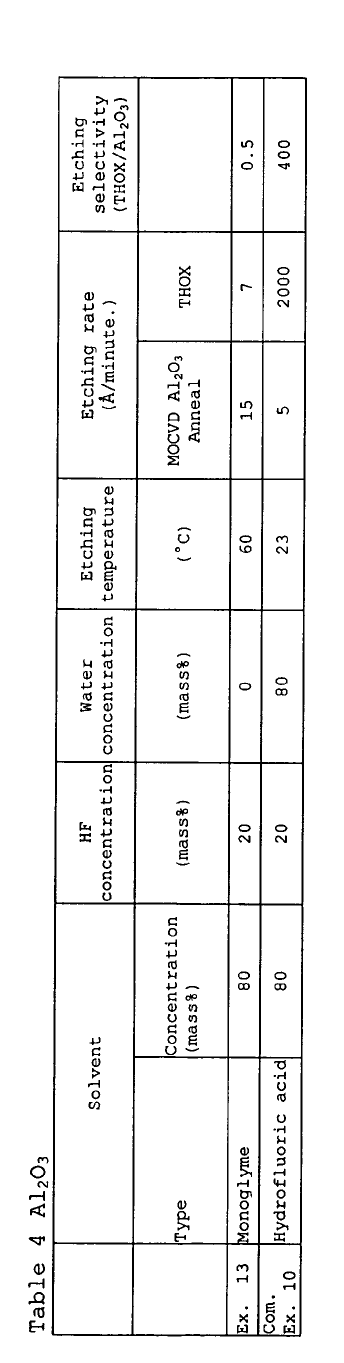

## Claims

1. An etching solution having an etch rate of 2 Å/minute or greater for a film having a relative dielectric constant of 8 or higher (a High-k film), and whose ratio of the etch rate for a thermal oxide (THOX) film to the etch rate for a High-k film ([THOX etch rate]/[High-k film etch rate]) is 50 or less.

2. An etching solution according to Claim 1, wherein the High-k film has a relative dielectric constant of 15 or greater.

3. An etching solution according to Claim 1, wherein the High-k film is a hafnium oxide film, a zirconium oxide film, or a lanthanum oxide film.

4. An etching solution according to Claim 1, wherein the High-k film comprises at least one member selected from the group consisting of hafnium silicate (HfSiOₓ), hafnium aluminate (HfAlO), HfSiON, HfAlON, ZrSiO, ZrAlO, ZrSiON, ZrAlON, alumina (Al₂O₃), HfON, ZrON and Pr₂O₃.

5. An etching solution according to Claim 1, wherein the etch rate for the thermal oxide (THOX) film is 100 Å/minute or less.

6. An etching solution according to Claim 1, which contains hydrogen fluoride (HF).

7. An etching solution according to Claim 1, wherein the hydrogen fluoride concentration is 3 mass% or greater.

8. An etching solution according to Claim 1, which contains hydrogen fluoride and an organic solvent comprising a heteroatom.

9. An etching solution according to Claim 8, wherein the organic solvent comprising a heteroatom is an ether compound, a ketone compound, or a sulfur-containing heterocyclic compound.

10. An etching solution according to Claim 9, wherein the organic solvent comprising a heteroatom is an ether compound.

11. An etching solution according to Claim 10, wherein the ether compound is at least one member selected from the group consisting of compounds represented by General Formula (1)
R¹-O-(CH₂CH₂-O)ₙ-R² (1)
wherein n is 1, 2, 3 or 4, R¹ and R² may be the same or different and each represents a hydrogen atom, a lower alkyl group or a lower alkyl carbonyl group, with the proviso that R¹ and R² are not both hydrogen atoms.

12. An etching solution according to Claim 10, wherein the ether compound has a relative dielectric constant of 30 or less.

13. An etching solution according to Claim 8, wherein the organic solvent comprising a heteroatom contains at least one carbonyl group in its molecular.

14. An etching solution according to Claim 8, wherein the organic solvent comprising a heteroatom has at least one hydroxy group in its molecular.

15. An etching solution according to Claim 10, wherein the ether compound is at least one member selected from the group consisting of tetrahydrofuran, tetrahydropyran, furan, furfural, γ-butyrolactone, monoglyme, diglyme, and dioxane.

16. An etching solution according to Claim 10, wherein the ether compound is at least one member selected from the group consisting of ethylene glycol methyl ethyl ether, ethylene glycol diethyl ether, diethylene glycol methyl ethyl ether, diethylene glycol diethyl ether, triethylene glycol dimethyl ether, triethylene glycol diethyl ether, triethylene glycol ethylmethyl ether, tetraethylene glycol dimethyl ether, tetraethylene glycol diethyl ether, and polyethylene glycol dimethyl ether.

17. An etching solution according to Claim 10, wherein the ether compound is at least one member selected from the group consisting of ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triethylene glycol monomethyl ether acetate and triethylene glycol monoethyl ether acetate.

18. An etching solution according to Claim 10, wherein the ether compound is at least one member selected from the group consisting of an ethylene glycol monomethyl ether, ethylene glycol monoethyl ether, ethylene glycol monopropyl ether, polyethylene glycol monomethyl ether, ethylene glycol monoisopropyl ether, ethylene glycol monobutyl ether, propylene glycol monomethyl ether, propylene glycol monopropyl ether and propylene glycol monobutyl ether.

19. An etching solution according to Claim 9, wherein the sulfur-containing heterocyclic compound is at least one member selected from the group consisting of sulfolane and propane sultone.

20. An etching solution according to Claim 1, which contains hydrogen fluoride (HF) and an organic solvent comprising a heteroatom, wherein the ratio of HF : heteroatom-comprising organic solvent : water = 3 mass% or greater : 50 to 97 mass% : 10 mass% or less.

21. A method for producing an etched article using the etching solution of Claim 1, the method comprising a step of etching an object to be etched having a silicon oxide film and a film having a relative dielectric constant of 8 or greater, and a gate electrode that is formed on the film having a relative dielectric constant of 8 or greater.

22. An etched article obtained by the method of Claim 21.
